## Europäisches Patentamt
## European Patent Office
## Office européen des brevets

(19)

(11) Veröffentlichungsnummer: **0 171 692**
**B1**

(12)

# EUROPÄISCHE PATENTSCHRIFT

(45) Veröffentlichungstag der Patentschrift:
**08.11.89**

(51) Int. Cl.⁴: **H 04 M 3/00, H 04 M 19/00, H 03 H 11/28**

(21) Anmeldenummer: **85109452.4**

(22) Anmeldetag: **27.07.85**

(54) Teilnehmeranschlussschaltung.

(30) Priorität: **30.07.84 DE 3428106**

(43) Veröffentlichungstag der Anmeldung:
**19.02.86 Patentblatt 86/8**

(45) Bekanntmachung des Hinweises auf die Patenterteilung:
**08.11.89 Patentblatt 89/45**

(84) Benannte Vertragsstaaten:
**AT DE FR GB NL**

(56) Entgegenhaltungen:
**DE-A- 2 434 947**
**DE-A- 2 838 038**
**DE-A- 3 237 681**
**DE-A- 3 246 144**
**DE-B- 2 035 969**

ERICSSON REVIEW, Vol. 60, no. 4, 1983, Stockholm, Schweden A. RYDIN UND J. SUNDVALL "Line circuit component SLIC for AXE 10"

(73) Patentinhaber: **ALCATEL N.V.,**
**Strawinskylaan 537 (World Trade Center), NL-1077 XX Amsterdam (NL)**
(84) Benannte Vertragsstaaten: **FR GB NL AT**

(73) Patentinhaber: **Standard Elektrik Lorenz Aktiengesellschaft, Lorenzstrasse 10, D-7000 Stuttgart 40 (DE)**
(84) Benannte Vertragsstaaten: **DE**

(72) Erfinder: **Meschkat, Peter, Mayenner Strasse 10/1, D-7050 Waiblingen (DE)**
Erfinder: **Zanzig, Jürgen, Blammerbergstrasse 39, D-7252 Weil der Stadt (DE)**

(74) Vertreter: **Villinger, Bernhard, Dipl.-Ing. et al, Standard Elektrik Lorenz AG Patent- und Lizenzwesen Postfach 30 09 29, D-7000 Stuttgart 30 (DE)**

## Beschreibung

Die Erfindung betrifft eine Teilnehmeranschlußschaltung nach dem Oberbegriff des Hauptanspruchs.

Eine solche Teilnehmeranschlußschaltung wird in der Figur C auf Seite 195 der Zeitschrift Ericsson Review (Nr. 4, 1983) in dem Artikel «Line Circuit Component SLIC for AXE 10» (Seiten 192 bis 200) von A. Rydin und J. Sundvall durch ein Blockschaltbild vorgestellt. Derartige Teilnehmeranschlußschaltungen sollen in sehr großen Stückzahlen möglichst kostengünstig zur Verfügung stehen. Daher kommen nur Realisierungen in integrierter Schaltungstechnik in Frage. Außerdem werden nur sehr geringe Toleranzen zugelassen. Deshalb ist es erwünscht, die Anzahl derjenigen Bauelemente, die sich auf die Toleranzen auswirken, möglichst gering zu halten. Insbesondere soll mit möglichst wenig Aufwand eine möglichst gute Anpassung an äußere komplexe Impedanzen erzielt werden.

Der Erfindung liegt die Aufgabe zugrunde, eine Teilnehmeranschlußschaltung zum impedanzangepaßten Anschluß eines Teilnehmerapparates an eine Vermittlungseinrichtung zu entwickeln.

Die Aufgabe wird erfindungsgemäß gelöst durch eine Teilnehmeranschlußschaltung mit den Merkmalen des Anspruchs 1. Weitere erfindungsgemäße Ausgestaltungen sind den Ansprüchen 2 bis 4 zu entnehmen.

Im folgenden wird die Erfindung anhand von Ausführungsbeispielen unter Zuhilfenahme der beiliegenden Zeichnung weiter erläutert.

Figur 1 zeigt in vereinfachter Darstellung eine Teilnehmeranschlußschaltung nach dem Stand der Technik.

Figur 2 zeigt in gleichartiger Darstellung wie Fig. 1 eine erfindungsgemäße Teilnehmeranschlußschaltung.

Figur 3 zeigt eine weiter ausgestaltete erfindungsgemäße Teilnehmeranschlußschaltung.

Figur 4 zeigt in größerer Ausführlichkeit eine erfindungsgemäße steuerbare Stromquelle einer Teilnehmeranschlußschaltung.

Figur 5a und 5b zeigen Beispiele für die komplexen Impedanzen $Z_2$ und $Z_p'$.

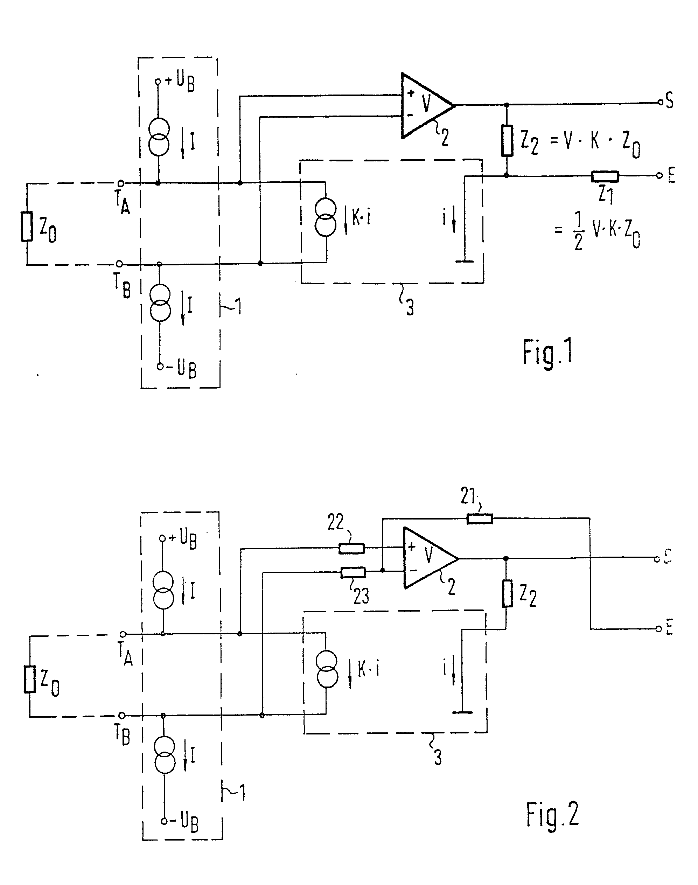

Anhand der Figur 1 wird zunächst eine Teilnehmeranschlußschaltung nach dem Stand der Technik beschrieben. Die Darstellung entspricht weitgehend der in Figur C des obengenannten Zeitschriftenartikels. An zwei Teilnehmerklemmen $T_A$ und $T_B$ ist über eine Zweidrahtleitung ein Teilnehmerapparat angeschlossen. Sowohl der Abschlußwiderstand des Teilnehmerapparates als auch der Leitungswiderstand der Zweidrahtleitung ist gleich der komplexen Impedanz $Z_0$. Der Teilnehmerapparat wird von einer Speiseschaltung 1 mit einem konstanten Gleichstrom I und von einer steuerbaren Stromquelle 3 mit einem Wechselstrom $K \cdot i$ gespeist. Der Wechselstrom i enthält die vom Teilnehmerapparat zu empfangende Information, der Gleichstrom I speist den Teilnehmerapparat.

Die vom Teilnehmerapparat gesendete Wechselspannung gelangt an die Eingänge eines Differenzverstärkers 2 mit der Verstärkung V. Die äußere Beschaltung des Differenzverstärkers 2 ist hier nicht dargestellt. Der Ausgang des Differenzverstärkers 2, dessen anderer Pol geerdet ist, ist mit einer Sendeleitung S verbunden. Vom Ausgang des Differenzverstärkers 2 führt außerdem ein Rückkopplungszweig zum Eingang der steuerbaren Stromquelle 3. Der Rückkopplungszweig enthält eine komplexe Impedanz $Z_2$. Diese komplexe Impedanz $Z_2$ ist so bemessen, daß an den Teilnehmerklemmen $T_A$ und $T_B$ die Teilnehmeranschlußschaltung an die Zweidrahtleitung und den daran angeschlossenen Teilnehmerapparat angepaßt ist. Der Wert der komplexen Impedanz $Z_2$ ist deshalb ein reelles Vielfaches der Impedanz $Z_0$, solange in der Teilnehmeranschlußschaltung keine Phasenverschiebungen auftreten. Der Wert der Impedanz $Z_2$ ist in diesem Beispiel gleich dem Wert der Impedanz $Z_0$ multipliziert mit dem Verstärkungsfaktor V des Differenzverstärkers 2 und der übertragungskonstanten K der steuerbaren Stromquelle. Der Eingang der steuerbaren Stromquelle ist ein Stromeingang, der über einen vernachlässigbaren Innenwiderstand geerdet ist. Die Ausgangsströme der steuerbaren Stromquelle 3 unterscheiden sich nach Betrag und Phase von dem in den Steuereingang hineinfließenden Strom i nur durch die reelle Übertragungskonstante K; die beiden Ausgangsströme sind zueinander invers. Der Steuereingang der steuerbaren Stromquelle 3 ist außerdem mit einer Empfangsleitung E verbunden. Ein an der Empfangsleitung E ankommendes Empfangssignal gelangt über die steuerbare Stromquelle 3 und die Zweidrahtleitung zum Teilnehmerapparat. Durch die komplexe Impedanz der Anordnung ergäben sich Frequenzgangverzerrungen auf dem Weg von der Empfangsleitung E zu den Teilnehmerklemmen $T_A$, $T_B$. Diese Frequenzgangverzerrungen werden durch eine zwischen die Empfangsleitung E und den Eingang der steuerbaren Stromquelle 3 eingefügte komplexe Impedanz $Z_1$ ausgeglichen. Auch der Wert dieser komplexen Impedanz $Z_1$ ist ein reelles Vielfaches des Werts der Impedanz der Zweidrahtleitung und des Teilnehmerapparates. Im gezeigten Beispiel ist der Wert der komplexen Impedanz $Z_1$ gleich der Hälfte des Werts der Impedanz $Z_0$ multipliziert mit dem Verstärkungsfaktor V des Differenzverstärkers und mit der Übertragungskonstanten K der steuerbaren Stromquelle 3 und damit halb so groß wie die komplexe Impedanz $Z_2$.

Die Erfindung nützt die Tatsache, daß die vorhandenen Impedanzen zu einander in einem reellen Verhältnis stehen. Wie Figur 2 zeigt, wird das von der Empfangsleitung E kommende Empfangssignal so zum Eingang der steuerbaren Stromquelle 3 geführt, daß es dabei auch über die komplexe Impedanz $Z_2$ läuft. Es wird hierzu an einen Eingang des Differenzverstärkers 2 gegeben, dessen Ausgang über die komplexe Impedanz $Z_2$ mit dem Eingang der steuerbaren Stromquelle 3 verbunden ist. In die Verbindungen zwischen den Teilnehmerklemmen $T_A$ und $T_B$ und den Eingängen des Differenzverstärkers 2, sowie zwischen der Empfangsleitung E und dem Differenzverstärker 2 sind Widerstände 22, 23 und 21 eingefügt. Die Widerstände 22 und 23 sind untereinander gleich, das Verhältnis der Widerstände 22 und 21 zueinander ergibt sich aus dem Verhältnis der ursprünglich zwei komplexen Impedanzen $Z_1$ und $Z_2$.

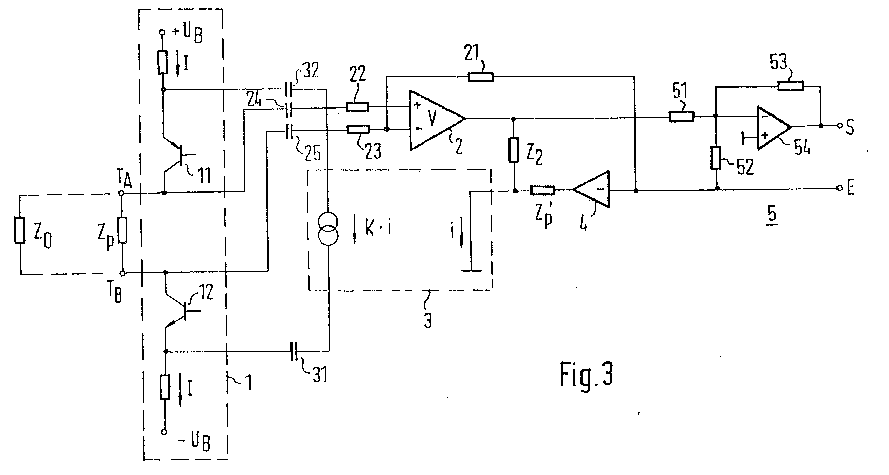

Die Schaltung nach Figur 3 zeigt eine Ausgestaltung der Schaltung nach Figur 2. Außer den gewünschten Impedanzen sind, sowohl in der Schaltung nach Figur 1, als auch in der Schaltung nach Figur 2, auch parasitäre Impedanzen vorhanden. Eine derartige komplexe Impedanz $Z_p$ ist in Figur 3 zwischen den Teilnehmerklemmen $T_A$ und $T_B$ eingezeichnet. Die anhand der Figur 2 erklärte erfindungsgemäße Führung des Empfangssignals macht es möglich, diese parasitäre Impedanz $Z_p$ durch eine zwischen die Eingangsleitung E und den Eingang der steuerbaren Stromquelle 3 eingefügte Ausgleichimpedanz $Z_p'$ auszugleichen. Im Schaltungsbeispiel nach Figur 3 ist hierzu in Reihe mit der Ausgleichsimpedanz $Z_p'$ noch ein Inverter 4 erforderlich. Gemäß einer weiteren Ausgestaltung der Erfindung, die auch schon auf die Schaltung nach Figur 1 anwendbar ist, erfolgt die Einspeisung des Ausgangsstroms der steuerbaren Stromquelle 3 nicht direkt auf die Teilnehmerklemmen $T_A$ und $T_B$, sondern über Emitter-Kollektor-Strecken von Transistoren 11 und 12 die in der Speiseschaltung 1 zur Einspeisung des Konstantstroms 1 ohnehin vorhanden sind. Dies hat verschiedene Vorteile, beispielsweise gelangen Störspannungen, die auf der Zweidrahtleitung auftreten, nicht an die steuerbare Stromquelle 3. Geeignete Speiseschaltungen sind beispielsweise aus den deutschen Offenlegungsschriften 3 237 681 und 3 246 144 bekannt. Diese Stromeinspeisung erlaubt es auch, die steuerbare Stromquelle 3 durch Koppelkondensatoren 31 und 32 mit geringen Spannungsfestigkeiten und großen Toleranzen galvanisch von der Zweidrahtleitung zu trennen. Auch der Differenzverstärker 2 wird, wie allgemein üblich, durch Koppelkondensatoren 24 und 25 galvanisch von der Zweidrahtleitung getrennt.

Weiter ist in Figur 3 eine Gabelschaltung 5 eingefügt, die in bekannter Weise aufgebaut ist. Sie enthält einen Operationsverstärker 54, einen Rückkopplungswiderstand 53, einen den invertierenden Eingang des Operationsverstärkers 54 mit dem Ausgang des Differenzverstärkers 2 verbindenden Widerstand 51 und einen zwischen der Empfangsleitung E und dem invertierenden Eingang des Operationsverstärkers 54 liegenden Widerstand 52. Die Gabelschaltung 5 hat in bekannter Weise die Aufgabe, zu verhindern, daß von der Empfangsleitung E ein Signal zur Sendeleitung S übergekoppelt wird. Der Wert des Widerstands 51 ist dabei gleich dem Wert des Widerstands 52 multipliziert mit dem Verstärkungsfaktors V des Differenzverstärkers 2.

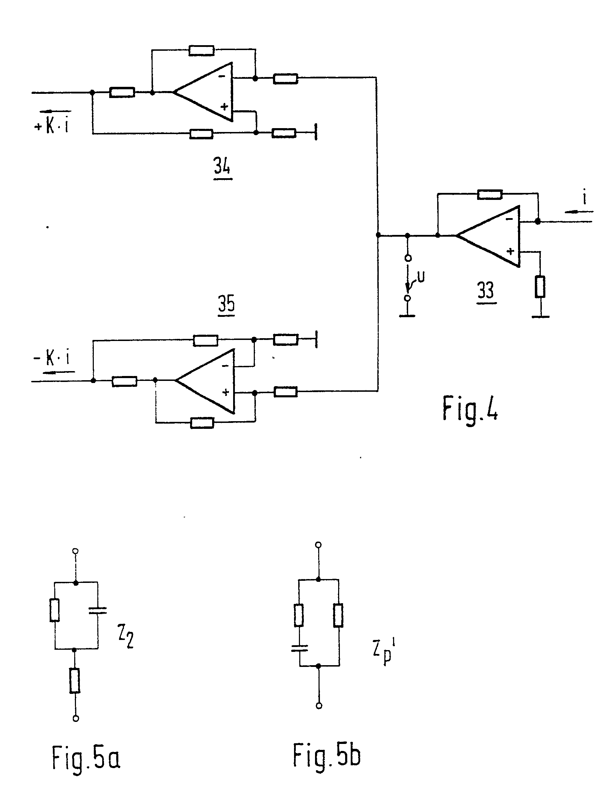

Anhand der Figur 4 wird ein vorteilhafter Aufbau einer steuerbaren Stromquelle 3 in einer der oben beschriebenen Schaltungen näher erläutert. Der Wechselstrom i wird in einem Strom-Spannungs-Wandler 33 in eine dem Strom i proportionale Ausgangsspannung u umgewandelt. Durch zwei zueinander parallel geschaltete und spiegelbildlich zueinander aufgebaute Spannungs-Strom-Wandler 34 und 35 wird die Spannung u wiederum in Wechselströme umgewandelt. Da diese Wechselströme zur Wechselspannung u proportional sind, sind sie auch zum Eingangsstrom i proportional. Es ergeben sich damit zwei zueinander inverse Ausgangsströme $+K \cdot i$ und $-K \cdot i$. Der nähere Aufbau der erforderlichen Strom-Spannungs- und Spannungs-Strom-Wandler ist bekannt, beispielsweise aus U. Tietze, Ch. Schenk, Halbleiterschaltungstechnik, 2. Auflage, Seite 209 und 243.

Figur 5a und Figur 5b zeigen den Aufbau der erforderlichen komplexen Impedanzen $Z_2$ und $Z_p'$. Die im Rückkopplungszweig liegende und die Anpassung bewirkende Impedanz $Z_2$ besteht aus der Reihenschaltung eines Widerstands mit der Parallelschaltung aus einem Widerstand und einem Kondensator (Figur 5a). Die die parasitäre Impedanz $Z_p$ an den Teilnehmerklemmen $T_A$ und $T_B$ ausgleichende Ausgleichsimpedanz $Z_p'$ besteht aus der Parallelschaltung eines Widerstands mit der Reihenschaltung aus einem Widerstand und einem Kondensator.

**Patentansprüche**

1. Teilnehmeranschlußschaltung zum impedanzangepaßten Anschluß eines über eine bidirektionale Zweidrahtleitung (TA, TB) angeschlossenen Teilnehmerapparates an eine Vermittlungseinrichtung über eine unidirektionale Empfangs- (E) und eine unidirektionale Sendeleitung (S), mit einer Speiseschaltung (1) zur Versorgung des Teilnehmerapparates mit einem Konstantstrom (I); mit einem Differenzverstärker (2), dessen beiden Eingängen das von der bidirektionalen Zweidrahtleitung (TA, TB) kommende Signal zugeführt wird und dessen Ausgang zur unidirektionalen Sendeleitung (S) führt; mit einer steuerbaren Stromquelle (3), deren Ausgangsstrom (Ki) durch den von der unidirektionalen Empfangsleitung (E) kommenden Strom (i) gesteuert und dem von der Speiseschaltung kommenden Konstantstrom (I) überlagert wird; mit einem Rückkoppelzweig, der den Ausgang des Differenzverstärkers mit dem Eingang der steuerbaren Stromquelle verbindet und der eine komplexe Impedanz (Z2) enthält, deren Wert gleich einem reellen Vielfachen des Leitungswiderstands (Z0) der bidirektionalen Zweidrahtleitung (TA, TB) ist; und mit einer zwischen der unidirektionalen Empfangsleitung (E) und dem Eingang der steuerbaren Stromquelle im Weg des Empfangssignals liegenden komplexen Impedanz, deren Wert ebenfalls gleich einem reellen Vielfachen des Leitungswiderstands (Z0) der bidirektionalen Zweidrahtleitung (TA, TB) ist, dadurch gekennzeichnet, daß das von der Empfangsleitung (E) kommende Empfangssignal derart einem Eingang des Differenzverstärkers (2) zugeführt wird, daß das Empfangssignal durch den Rückkoppelzweig und die darin enthaltene komplexe Impedanz (Z2) verläuft, so daß diese Impedanz gleichzeitig die im Weg des Empfangssignals liegende Impedanz ist.

2. Teilnehmeranschlußschaltung nach Anspruch 1, dadurch gekennzeichnet, daß zwischen die Empfangsleitung (E) und die steuerbare Stromquelle (3) eine Impedanz ($Z_p'$) eingefügt ist.

3. Teilnehmeranschlußschaltung nach Anspruch 1 oder 2, dadurch gekennzeichnet, daß die steuerbare Stromquelle (3) einen Strom-Spannungs-Wandler (33) und zwei nachgeschaltete Spannungs-Strom-Wandler (34, 35) enthält und daß die Ausgangsströme der beiden Spannungs-Strom-Wandler (34, 35) zueinander invers sind.

4. Teilnehmeranschlußschaltung nach einem der Ansprüche 1 bis 3, dadurch gekennzeichnet, daß der Ausgangsstrom der steuerbaren Stromquelle (3) über die Emitter-Kollektor-Strecken der in der Speiseschaltung (1) zur Einspeisung des Konstantstroms vorhandenen Transistoren (11, 12) eingespeist wird.

## Claims

1. Line circuits for connecting a subscriber set, connected to the line circuit by a bidirectional two-wire line (TA, TB), to a switching facility by a unidirectional receive line (E) and a unidirectional transmit line (S) so as to obtain an impedance match, said line circuit comprising a feed circuit (1) for supplying a constant current (I) to the subscriber set, a differential amplifier (2) whose two inputs are fed with the signal coming from the bidirectional two-wire line (TA, TB), and whose output is connected to the unidirectional transmit line (S), a controlled current source (3) whose output current (Ki) is controlled by the current (i) coming from the unidirectional receive line (E) and is superimposed on the constant current (I) coming from the feed circuit, a feedback path connecting the output of the differential amplifier with the input of the controlled current source and containing a complex impedance (Z2) having a value equal to a real multiple of the impedance (Z0) of the bidirectional two-wire line (TA, TB), and a complex impedance contained in the path for the received signal between the unidirectional receive line (E) and the input of the controlled current source and having a value equal to a real multiple of the impedance (Z0) of the bidirectional two-wire line (TA, TB), characterized in that the signal coming from the receive line (E) is routed in such a way that it passes through one input of the differential amplifier (2) and through the feedback path and the complex impedance contained therein, so that this impedance is also the impedance contained in the path for the received signal.

2. A line circuit as claimed in claim 1, characterized in that an impedance ($Z_p'$) is interposed between the receive line (E) and the controlled current source (3).

3. A line circuit as claimed in claim 1 or 2, characterized in that the controlled current source (3) contains a current-to-voltage converter (33) followed by two voltage-to-current converters (34, 35), and that the output currents of the two voltage-to-current converters (34, 35) are inverse to each other.

4. A line circuit as claimed in any one of claims 1 to 3, characterized in that the output current of the controlled current source (3) is fed into the circuit through the emitter-collector paths of transistors (11, 12) contained in the feed circuit (1).

## Revendications

1. Circuit de ligne pour le raccordement d'un poste d'abonné, connecté au circuit de ligne par une ligne deux-fils bidirectionnelle (TA, TB), à une installation de commutation, par une ligne réception unidirectionnelle (E) et une ligne émission unidirectionnelle (S), en réalisant une adaptation d'impédance, ledit circuit de ligne comprenant un circuit d'alimentation (1) pour fournir un courant constant (I) au poste d'abonné, un amplificateur différentiel (2) aux deux entrées duquel est fourni le signal venant de la ligne deux-fils bidirectionnelle (TA, TB) et dont la sortie est connectée à la ligne émission unidirectionnelle (S), une source de courant commandé (3) dont le courant de sortie (Ki) est commandé par le courant (i) venant de la ligne réception unidirectionnelle (E) et est superposé au courant constant (I) venant du circuit d'alimentation, un trajet de contre-réaction connectant la sortie de l'amplificateur différentiel à l'entrée de la source de courant commandé et comprenant une impédance complexe (Z2) ayant une valeur égale à un multiple réel de l'impédance (Z0) de la ligne deux-fils bidirectionnelle (TA, TB), ainsi qu'une impédance complexe interposée dans le trajet du signal de réception, entre la ligne réception unidirectionnelle (E) et l'entrée de la source de courant commandé, et ayant une valeur égale à un multiple réel de l'impédance (Z0) de la ligne deux-fils bidirectionnelle (TA, Tb), caractérisé en ce que le signal venant de la ligne de réception (E) est appliqué à l'une des deux entrées de l'amplificateur différentiel (2), en ce que le signal de réception parcourt le trajet de contre-réaction et l'impédance complexe (Z2) qu'il contient, de sorte que cette impédance est simultanément ladite impédance se trouvant dans ledit trajet de réception.

2. Circuit de ligne conforme à la revendication 1, caractérisé en ce qu'une impédance ($Z_p'$) est interposée entre la ligne réception (E) et la source de courant commandé (3).

3. Circuit de ligne conforme à la revendication 1 ou 2, caractérisé en ce que la source de courant commandé (3) comprend un convertisseur courant-tension (33) et deux convertisseurs tension-courant (34, 35) et en ce que les courants de sortie des deux convertisseurs tension-courant (34-35) sont inverses l'un de l'autre.

4. Circuit de ligne conforme à l'une quelconque des revendications 1 à 3, caractérisé en ce que le courant de sortie de la source de courant commandé (3) est fourni par l'intermédiaire des trajets émetteur-collecteur de transistors (11, 12) contenus dans le circuit d'alimentation (1) pour la fourniture dudit courant constant.

$Z_2 = V \cdot K \cdot Z_0$

$Z_1 = \frac{1}{2} V \cdot K \cdot Z_0$

Fig.1

Fig.2

Fig.3

EP 0 171 692 B1

Fig.4

Fig.5a

Fig.5b